# DEMANDE DE BREVET EUROPEEN

(11) **EP 2 544 242 A1**
(43) Date de publication de la demande: **09.01.2013**
(21) Numéro de dépôt: 12175022.8
(22) Date de dépôt: 04.07.2012
(51) Int. Cl.: H01L 31/0236, H01L 21/308, B29C 43/02, B05D 1/28, B05D 1/32, G03F 7/00

(54) **Procédé de texturation d'une cellule photovoltaïque**

(30) Priorité: 04.07.2011 FR 1156000
(71) Demandeur: MPO Energy, 53700 Averton (FR)
(72) Inventeur: Bechevet, Bernard, 74420 Habere Poche (FR); Jourdan, Johann, 73000 Chambéry (FR); De Magnienville, Sylvin, 53370 Saint Pierre des Nids (FR); Thibert, Sébastien, 38000 Grenoble (FR); Reverdy-Bruas, Nadège, 38340 Voreppe (FR); Chaussy, Didier, 38320 Brié et Angonnes (FR); Beneventi, Davide, 38400 Saint Martin d'Hères (FR)
(74) Mandataire: Vigand, Philippe

(57) **Abrégé**

Procédé de texturation d'une face active d'une cellule photovoltaïque (10) en silicium monocristallin ou polycristallin comprenant les étapes consistant à déposer une résine (20) sur ladite face active, texturer la résine (20) sur cette face active avec des motifs géométriques, et texturer ladite face active en éliminant la résine (20) déposée, l'étape de dépose de la résine (20) étant précédée par une étape de pré-texturation de la résine (20) sur un outil de dépose (30), et l'étape de texturation de la résine (20) étant simultanée avec l'étape de dépose de la résine (20).

## Description

La présente invention concerne de manière générale une cellule photovoltaïque destinée à être montée sur un panneau solaire.

Il est connu dans l'art antérieur de telles cellules, réalisées soit en silicium monocristallin ou poly-cristallin. Un des facteurs influant sur le rendement de conversion de l'énergie solaire en énergie électrique est le taux d'absorption de l'énergie solaire. En d'autres termes, la réflectivité de la face active doit être la plus faible possible, car il faut que la cellule absorbe le plus de lumière possible. Conventionnellement, les faces actives des cellules sont géométriquement texturées pour en réduire la réflexion. Cette texturation est réalisée en général dans des bains par attaque chimique qui provoque une érosion. La mise en oeuvre de cette attaque chimique présente notamment l'inconvénient d'utiliser des liquides polluants et dont les coûts de stockage et recyclage sont importants. D'autre part, dans le cas des cellules en silicium poly-cristallin, la réduction du coefficient de réflexion par l'attaque chimique est limitée car les géométries de texturation obtenues sont aléatoires, de sorte que le rendement n'est pas significativement amélioré. Cette érosion peut être également réalisée par une attaque plasma, mais également, les texturations obtenues sont aléatoires, de sorte que le rendement n'est pas significativement amélioré dans le cas de cellules en silicium monocristallin ou poly-cristallin.

Le document FR 2 935 842 présente un procédé de texturation comportant une dépose de résine suivi de sa texturation et ensuite une texturation de la cellule en retirant par érosion toute la résine précédemment déposée, de sorte que les motifs de texturation de la résine sont reproduits sur la cellule. Néanmoins, ce procédé n'est pas adapté à la production de cellules photovoltaïques en conditions industrielles car la mise en forme de la résine, i.e. sa texturation est réalisée après sa dépose à l'aide d'un moule de texturation. Ce moule exerce une pression sur la cellule et la maîtrise des efforts n'est pas garantie dans un procédé à grande cadence, de sorte que de nombreuses casses de cellules auront lieu, en raison de leur fragilité causée par leur épaisseur très faible. On peut ajouter que ce point est essentiel, en raison de la réduction permanente de l'épaisseur des cellules, afin d'économiser le silicium. Ensuite l'application du moule sur la cellule impose des arrêts dans l'avance des cellules et un séquencement de la fabrication limitant la productivité.

Un but de la présente invention est de répondre aux inconvénients des documents de l'art antérieur mentionnés ci-dessus et en particulier, tout d'abord, de proposer un procédé de texturation d'une cellule photovoltaïque compatible avec une fabrication industrielle en grande série sans risque de casse des cellules dans leur épaisseur actuelle et compatible avec de futures réductions d'épaisseur.

Pour cela un premier aspect de l'invention concerne un procédé de texturation d'une face active d'une cellule photovoltaïque comprenant les étapes consistant à :
- déposer une résine sur la face active de la cellule,
- texturer la résine sur la face active avec des motifs géométriques,
- texturer la face active de la cellule en éliminant la résine déposée ;
**caractérisé en ce que**
- l'étape de dépose de la résine est précédée par une étape de pré-texturation de la résine sur un outil de dépose, et en ce que
- l'étape de texturation de la résine sur la face active est simultanée avec l'étape de dépose de la résine sur la face active.

Le procédé selon l'invention augmente la productivité de la texturation en pré-texturant la résine lors de sa dépose sur l'outil de dépose et en réalisant la texturation finale de la résine simultanément à l'application de celle-ci sur la face active de la cellule. Une seule opération sur la cellule (dépose et texturation) au lieu de deux permet de simplifier les équipements et de gagner du temps de fabrication. La texturation de la résine et celle de la face active lors de l'élimination de la résine évitent de recourir à des bains de liquide pour appliquer un motif prédéfini de texturation à la face active qui diminue notablement le coefficient de réflexion des cellules traitées, aussi bien en silicium monocristallin, qu'en silicium poly-cristallin. En effet, ces cellules rigides sont fragiles et la simultanéité des opérations de dépose et de texturation évite de multiplier des opérations qui risquent de les casser.

De manière avantageuse, les étapes simultanées de dépose et de texturation de la résine sur la face active appliquent des efforts sur la face active de la cellule photovoltaïque et le procédé comporte une étape de reprise d'efforts sur une face opposée à la face active de la cellule photovoltaïque, simultanée aux étapes de dépose et texturation de la résine. Les cellules sont protégées des efforts appliqués à la dépose et la texturation finale par l'étape simultanée de reprise d'effort lors de la dépose et de la texturation de la résine. Ainsi, ce procédé ne crée pas de contraintes dans la cellule lors de la texturation de la résine, ce qui offre la possibilité de réduire encore l'épaisseur des cellules sans remettre en cause les équipements de production.

Une réalisation particulièrement intéressante consiste en ce que les étapes de dépose et de texturation de la résine sur la face active sont réalisées par un procédé de flexographie ou d'impression offset. Ces procédés de dépose de résine par un rouleau enduit de résine et gravé avec les motifs de texturation convient tout à fait à la texturation des cellules planes et fragiles. De plus, l'étape de reprise d'effort peut être intégrée à ce procédé en ajoutant un contre rouleau sous les cellules. Les cadences de production sont élevées et permettent une réduction des coûts de fabrication.

Avantageusement, les étapes simultanées de dépose et de texturation de la résine sur la face active sont réalisées en continu avec des étapes d'alimentation et d'évacuation des cellules photovoltaïques réalisées par un convoyeur. Le procédé de flexographie est un procédé en continu et les étapes de dépose et texturation par un tambour peuvent tout à fait se réaliser en ligne avec un convoyeur, pour une productivité élevée.

Avantageusement, les étapes d'alimentation et d'évacuation sont réalisées dans un même plan. Cette mise en oeuvre assure qu'aucune déflexion ou déformation ne sera imposée aux cellules afin de ne pas les casser. On peut noter que la flexographie (utilisée conventionnellement pour des supports souples) permet, grâce à cette alimentation et évacuation coplanaires de déposer et texturer des cellules rigides, en limitant les déformations imposées pour rester dans le domaine élastique très restreint de ces cellules rigides. En d'autres termes, le procédé selon la présente invention comprend une limitation des déformations imposées aux cellules pendant la dépose et texturation de la résine, de sorte à ce que ces déformations restent dans le domaine élastique des cellules photovoltaïques en silicium monocristallin ou poly-cristallin. Cela revient à limiter les contraintes imposées aux cellules photovoltaïques en silicium monocristallin ou poly-cristallin pour que ces contraintes n'excèdent pas la limite de résistance élastique du matériau.

Un second aspect de l'invention est une cellule photovoltaïque fabriquée par un procédé selon le premier aspect de l'invention.

Un troisième aspect de l'invention est un panneau solaire comprenant au moins une cellule photovoltaïque selon le deuxième aspect de l'invention.

Un dernier aspect de l'invention est un équipement de fabrication apte à mettre en oeuvre le procédé selon le premier aspect de l'invention et comportant un outil de dépose de résine sur une face active de cellule photovoltaïque, **caractérisé en ce que** l'outil de dépose de résine comporte des moyens de pré-texturation de la résine lorsqu'elle est déposée sur l'outil de dépose et en ce que l'outil de dépose est apte à texturer la résine lors de sa dépose sur la face active de la cellule photovoltaïque.

Avantageusement, l'outil de dépose est un rouleau de flexographie ou d'impression offset.

D'autres caractéristiques et avantages de la présente invention apparaîtront plus clairement à la lecture de la description détaillée qui suit d'un mode de réalisation de l'invention donné à titre d'exemple nullement limitatif et illustré par le dessin annexé, dans lequel :

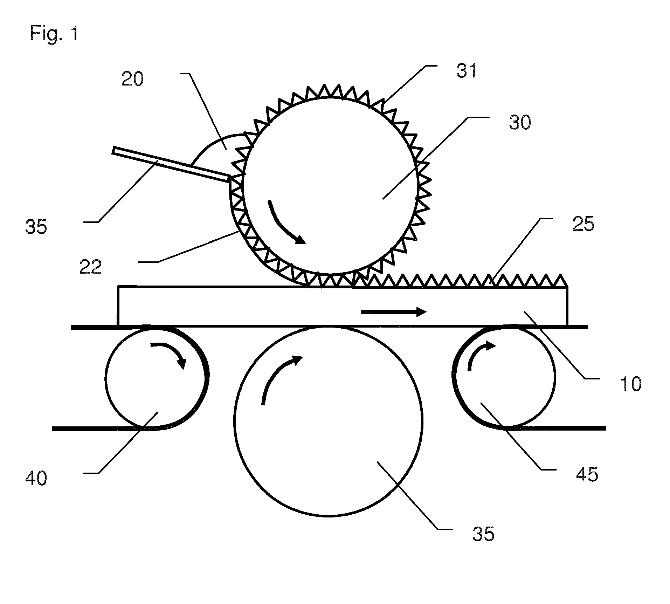

- la figure 1 représente une cellule photovoltaïque en cours d'enduction de résine.

La figure 1 représente une cellule photovoltaïque 10 menée par un convoyeur d'alimentation 40 vers un poste de flexographie. Ce poste de flexographie comporte un rouleau d'impression 30 et un rouleau de contre pression 35. Le rouleau d'impression 30 dépose de la résine 20 sur une face de la cellule 10. Le rouleau d'impression comporte des motifs géométriques 31 qui pré-texturent la résine sur le rouleau d'impression, après l'enduction réalisée par une racle 35. La résine 20 est donc pré-texturée en motifs 22. Lorsqu'elle est déposée sur la cellule 10, la résine est texturée dans sa forme finale 25, et se trouve évacuée par le convoyeur 45. Ensuite la résine peut soit être réticulée par UV ou chauffage avant d'être éliminée pour obtenir une texturation de la face active de la cellule elle-même. Les motifs 31 du rouleau d'impression peuvent être des pyramides par exemple pour que les motifs 25 provoquent une texturation adéquate de la face active pour en réduire son coefficient de réflexion. L'invention permet d'utiliser la flexographie pour enduire et texturer des cellules en silicium poly-cristallin ou monocristallin sans les casser. La flexographie est conventionnellement utilisée pour des supports souples qui présentent un module d'Young inférieur à 10GPa et qui tolèrent une déformation élastique élevée. La limitation des déflexions et déformations en ayant les convoyeurs 40 et 45 coplanaires permettent de simultanément enduire et texturer des cellules photovoltaïques sans les casser, même si elles présentent un module d'Young de l'ordre de 130 à 170GPa, en fonction de la direction cristallographique.

On comprendra que diverses modifications et/ou améliorations évidentes pour l'homme du métier peuvent être apportées aux différents modes de réalisation de l'invention décrits dans la présente description sans sortir du cadre de l'invention défini par les revendications annexées. En particulier, il est fait référence à un procédé de flexographie ou d'impression offset, mais tout procédé d'impression par rouleau d'impression et contre rouleau de pression peut être envisagé.

## Revendications

1. Procédé de texturation d'une face active d'une cellule photovoltaïque (10) en silicium monocristallin ou poly-cristallin comprenant les étapes consistant à :
- déposer une résine (20) sur la face active de la cellule (10),
- texturer la résine (20) sur la face active avec des motifs géométriques,
- texturer la face active de la cellule (10) en éliminant la résine (20) déposée ; **caractérisé en ce que**
- l'étape de dépose de la résine (20) est précédée par une étape de pré-texturation de la résine (20) sur un outil de dépose (30), et **en ce que**
- l'étape de texturation de la résine (20) sur la face active est simultanée avec l'étape de dépose de la résine (20) sur la face active.

2. Procédé de texturation selon la revendication 1, **caractérisé en ce que** les étapes simultanées de dépose et de texturation de la résine (20) sur la face active appliquent des efforts sur la face active de la cellule photovoltaïque (10) et **en ce que** le procédé comporte une étape de reprise d'efforts sur une face opposée à la face active de la cellule photovoltaïque (10), simultanée aux étapes de dépose et texturation de la résine (20).

3. Procédé de texturation selon l'une des revendications 1 ou 2, **caractérisé en ce que** les étapes de dépose et de texturation de la résine (20) sur la face active sont réalisées par un procédé de flexographie ou d'impression offset.

4. Procédé de texturation selon la revendication 3, **caractérisé en ce que** les étapes simultanées de dépose et de texturation de la résine (20) sur la face active sont réalisées en continu avec des étapes d'alimentation et d'évacuation des cellules photovoltaïques réalisées par un convoyeur (40, 45).

5. Procédé de texturation selon la revendication 4, **caractérisé en ce que** les étapes d'alimentation et d'évacuation sont réalisées dans un même plan.
